# EUROPÄISCHE PATENTSCHRIFT

(11) **EP 3 004 858 B1**
(45) Veröffentlichungstag und Bekanntmachung des Hinweises auf die Patenterteilung: **04.07.2018**
(21) Anmeldenummer: 14730740.9
(22) Anmeldetag: 30.05.2014
(51) Int. Cl.: G01N 27/403, G01N 27/30, B01L 3/00

(54) **VERFAHREN ZUM ERZEUGEN EINER VIELZAHL VON MESSBEREICHEN AUF EINEM CHIP SOWIE CHIP MIT MESSBEREICHEN**
METHOD OF PRODUCING A MULTITUDE OF MEASURING ZONES ON A CHIP AND CHIP WITH MEASURING ZONES
PROCÉCÉ POUR PRODUIRE UNE PLURALITÉ DE ZONES DE MESURE SUR UNE PUCE ET PUCE POURVUE DE ZONES DE MESURE

(30) Priorität: 30.05.2013 DE 102013210138
(43) Veröffentlichungstag der Anmeldung: 13.04.2016
(73) Patentinhaber: Boehringer Ingelheim Vetmedica GmbH, 55216 Ingelheim am Rhein (DE)
(72) Erfinder: SCHIEBER, Markus, 80469 München (DE); SCHOEDER, Heinz, 55216 Ingelheim am Rhein (DE)
(74) Vertreter: Von Rohr Patentanwälte Partnerschaft mbB
(86) Internationale Anmeldenummer: PCT/EP2014/001462
(87) Internationale Veröffentlichungsnummer: WO 2014/191114

(56) Entgegenhaltungen:
- US-A1- 2002 123 048
- US-A1- 2003 194 709
- US-A1- 2004 058 423
- US-B1- 6 183 970

## Beschreibung

Die Erfindung betrifft ein Verfahren zum Erzeugen einer Vielzahl von Messbereichen auf einem Chip, wobei auf dem Chip in jedem der Messbereiche elektrisch kontaktierbare Elektrodenpaarungen strukturiert sind und wobei die Messbereiche durch Ausbilden einer die Messbereiche voneinander trennenden Compartment-Struktur ausgebildet werden.

Außerdem betrifft die Erfindung einen Chip mit einer Vielzahl von elektrisch adressierbaren Messbereichen, wobei auf der Chipoberfläche eine die Messbereiche voneinander trennende Compartment-Struktur vorgesehen ist.

Ein Chip der eingangs angegebenen Art sowie ein Verfahren zu dessen Herstellung ist beispielsweise aus der US 2009/0131278 A1 bekannt. Bei dem Chip handelt es sich um einen Chip auf Siliziumbasis, auf dessen Oberfläche durch Metallisieren und Strukturieren eine Vielzahl von Elektrodenpaarungen angeordnet ist. Diese befinden sich in einem zweidimensionalen Array bevorzugt in einer schachbrettartigen Anordnung. Die Elektrodenanordnungen bestehen aus ineinander verzahnten Elektrodenstreifen, die bewirken, dass die beiden Elektroden der Elektrodenanordnung über eine große Länge einander benachbart sind. Die Messbereiche sind dazu vorgesehen, mit bestimmten biologisch aktiven Substanzen funktionalisiert zu werden. Hierbei kann es sich beispielsweise um Antikörper handeln, die auf bestimmte Antigene chemisch reagieren, wobei diese chemische Reaktion elektrisch durch die Elektrodenanordnung nachweisbar ist. Die Funktionalisierung erfolgt durch ein sogenanntes Spotting-Verfahren, bei dem jeder Messbereich mit einer anderen beispielsweise wasserbasierten Lösung beaufschlagt wird. Hierbei werden die für die Funktionalisierung verantwortlichen Moleküle auf den entsprechenden Messbereichen immobilisiert. Dabei ist es von vorrangiger Bedeutung, dass sich die verschiedenen Flüssigkeiten der einzelnen Messbereiche nicht miteinander vermischen, damit auf jedem Messbereich nur eine Art von relevanten Molekülen vorhanden ist.

Um ein Vermischen von Flüssigkeiten benachbarter Spots zu verhindern, wird gemäß der US 2009/0131278 A1 vorgeschlagen, dass mechanische Barrieren in Form von kleinen Wänden zwischen den einzelnen Messbereichen vorgesehen werden können. Die Oberfläche des Chips wird somit sozusagen in verschiedene Fächer eines Kastens eingeteilt, wobei die Flüssigkeiten bei dem Spotting-Verfahren jeweils in eines der Fächer "eingefüllt" wird. Es ist aber zu berücksichtigen, dass sich die Fächer in einer Größenordnung von µm auf der Chipoberfläche erstrecken. Daher stößt die Wirkung der mechanischen Begrenzungen an ihre Grenzen. Aufgrund der Oberflächenspannung des Lösungsmittels, beispielsweise Wasser, kann es trotz der mechanischen Begrenzungen dazu kommen, dass sich die Flüssigkeiten benachbarter Messbereiche vereinigen und es so zu einer Durchmischung der relevanten funktionellen Moleküle kommt. Das Dokument US2003194709 beschreibt ebenso ein Verfahren zur Herstellung von hydrophilen Messbereichen auf einem Chip. Die Aufgabe der Erfindung liegt darin, ein Verfahren zum Erzeugen einer Vielzahl von Messbereichen auf einem Chip anzugeben sowie einen Chip anzugeben, der sich insbesondere mit diesem Verfahren herstellen lässt, wobei ein Mischen von Flüssigkeiten während des Spotting-Verfahrens zumindest weitgehend ausgeschlossen werden kann.

Die obige Aufgabe wird durch ein Verfahren gemäß unabhängigen Anspruch 1 gelöst. Vorteilhafte Weiterbildungen und Ausgestaltungen sind Gegenstand der Unteransprüche.

Es versteht sich von selbst, dass Ausgestaltungen, Ausführungsformen, Vorteile und dergleichen, welche nachfolgend zu Zwecken der Vermeidung von Wiederholungen nur zu einem Erfindungsaspekt angeführt sind, selbstverständlich auch in Bezug auf die übrigen Erfindungsaspekte entsprechend gelten.

Weiterhin versteht es sich von selbst, dass bei den nachfolgenden Werte-, Zahlen- und Bereichsangaben die angegebenen Werte bzw. Bereiche nicht beschränkend zu verstehen sind; es versteht sich für den Fachmann, dass einzelfallbedingt oder anwendungsbezogen von den angegebenen Bereichen und Angaben abgewichen werden kann, ohne dass der Rahmen der vorliegenden Erfindung verlassen ist.

Zudem gilt, dass alle im Folgenden genannten Werte bzw. Parameterangaben oder dergleichen grundsätzlich mit genormten oder explizit angegebenen Bestimmungsverfahren oder aber mit dem Fachmann an sich geläufigen Bestimmungsmethoden bestimmt bzw. ermittelt werden können. Dies vorausgeschickt, wird im Folgenden die vorliegende Erfindung näher beschrieben.

Gemäß einem Aspekt der vorliegenden Erfindung wird die Ausbildung der Compartment-Struktur vorzugsweise mit folgenden Verfahrensschritten vorgenommen. Zum einen werden hydrophile Eigenschaften in den Messbereichen erzeugt. Dies ist eine notwendige Voraussetzung dafür, dass sich die Messbereiche mit einer hydrophilen Flüssigkeit benetzen lassen. Allgemein werden die funktionellen Moleküle in Wasser gelöst, weswegen die hydrophilen Eigenschaften der Messbereiche von vorrangiger Bedeutung sind. Außerdem beinhaltet das erfindungsgemäße Verfahren ein Erzeugen von hydrophoben Benetzungseigenschaften auf der Chipoberfläche außerhalb der Messbereiche durch Aufbringen einer selbst organisierten Monolage, bestehend aus einer Fluorsilanverbindung. Als mögliche Fluorsilanverbindung kommt beispielsweise Teflon in Betracht (Polytetrafluoretylen oder PTFE). Es kann zum Beispiel (Tridecafluoro-1,1,2,2,-tetrahydrooctyl) trichlorosilane C8H4Cl3F13Si verwendet werden. Vorteilhaft ist die hydrophobe Wirkung dieser Monolage weitaus wirkungsvoller als eine mechanische Barriere. Dadurch, dass die Chipoberfläche zwischen den Messbereichen fast nicht durch hydrophile Flüssigkeiten benetzbar ist, ergibt sich zwischen den einzelnen Spots der funktionellen Flüssigkeiten ein Sicherheitsabstand, der ein Vermischen wirkungsvoll verhindert. Daher lassen sich vorteilhaft mit dem erfindungsgemäßen Verfahren zuverlässig funktionalisierte Chips herstellen.

Gemäß einem anderen Aspekt der vorliegenden Erfindung wird insbesondere ein Chip vorgeschlagen, wobei die Compartment-Struktur aus einer selbst organisierten (self assembling) Monolage, bestehend aus einer Fluorsilanverbindung, ausgebildet ist, die die Chipoberfläche außerhalb der Messbereiche bedeckt.

Eine Monolage entsteht, wenn lediglich eine Lage Moleküle auf der Chipoberfläche ausgebildet wird. Die Selbstorganisation der Monolage entsteht durch die Struktur der verwendeten Fluorsilanverbindung. Die Fluorsilanmoleküle weisen eine Trichlorosilangruppe auf, die gegenüber Silizium sehr affin ist, weswegen sich diese Gruppe auf der Oberfläche des Chips anordnet. Der Rest der Moleküle steht dann von der Oberfläche ab und bildet eine Oberfläche aus, die vergleichsweise hydrophob ist. Diese Hydrophobisierung der Oberfläche ist vorteilhaft sehr wirkungsvoll.

Gemäß einer Ausgestaltung des erfindungsgemäßen Verfahrens wird dieses zur Ausbildung der Compartment-Struktur mit folgenden Verfahrensschritten in der angegebenen Reihenfolge durchgeführt. Zunächst wird eine Fluorsilanverbindung als Monolage auf die Chipoberfläche aufgedampft. Dies passiert in Vakuumatmosphäre. Es können CVD- oder PVD-Verfahren zum Einsatz kommen. Anschließend erfolgt das Aufbringen einer photostrukturierbaren Schicht auf die Chipoberfläche. Diese bedeckt zunächst die komplette Chipoberfläche. Als nächstes werden über eine geeignete Maske die Messbereiche belichtet. Durch Entwickeln der photostruktierbaren Schicht entsteht eine photostrukturierte Schicht, wobei die Messbereiche freigelegt werden können. In den so freigelegten Messbereichen werden hydrophile Eigenschaften erzeugt, damit die wässrigen Lösungen dort aufgespottet werden können. Zum Schluss wird die photostrukturierbare Schicht entfernt.

Gemäß einer alternativen Ausgestaltung der Erfindung kann das Verfahren zur Ausbildung der Compartment-Struktur auch mit folgenden Verfahrensschritten in der angegebenen Reihenfolge ausgeführt werden. Zunächst werden die hydrophilen Eigenschaften auf der gesamten Chipoberfläche erzeugt. Anschließend wird eine photostrukturierbare Schicht auf die Chipoberfläche aufgebracht. Durch Belichten der Chipoberfläche außerhalb der Messbereiche kann diese photostrukturiert werden. Es entsteht eine photostrukturierte Schicht durch Entwickeln der photostrukturierbaren Schicht, wobei die Messbereiche durch die photostrukturierte Schicht abgedeckt werden. Anschließend erfolgt ein Aufdampfen einer Fluorsilanverbindung als Monolage auf der Chipoberfläche, und zwar in der oben bereits ausgeführten Weise. Zum Schluss wird die photostrukturierte Schicht entfernt.

Die beiden alternativen Verfahrensabläufe haben den großen Vorteil, dass die einzelnen Fertigungsschritte für sich gut bekannt sind und daher mit großer Prozesssicherheit ausgeführt werden können. Durch Steigerung der Prozesssicherheit werden daher vorteilhaft qualitativ hochwertige Ergebnisse erzielt.

Gemäß einer weiteren Ausgestaltung des Verfahrens ist vorgesehen, dass das Erzeugen der hydrophilen Eigenschaften in einem Sauerstoffplasma oder durch Trockenätzen vorgenommen wird. Diese beim Prozessieren von Wavern gebräuchlichen Verfahren können ebenfalls vorteilhaft mit einer hohen Prozesssicherheit angewendet werden.

Gemäß einer weiteren Ausgestaltung der Erfindung ist vorgesehen, dass nach Abschluss der Verfahrensschritte, wie sie oben bereits erläutert wurden, eine Reinigung der prozessierten Chipoberfläche erfolgt. Auf diese Weise kann die Chipoberfläche für ein nachträgliches Spotting-Verfahren vorbereitet werden. Kontaminationen werden vorteilhaft entfernt, so dass nach dem Spotting keine Messfehler wegen einer verunreinigten Oberfläche der Messbereiche auftreten. Die Reinigung der prozessierten Chipoberfläche kann den Abschluss für die Vorbereitung der Chips bilden. Diese werden anschließend so verpackt, dass eine erneute Reinigung der Chipoberfläche nicht notwendig ist. Der Anwender wird die Verpackung dann erst kurz vor dem Durchführen des Spotting-Verfahrens entfernen. Alternativ ist es selbstverständlich auch möglich, dass die Reinigung möglichst zeitnah vor dem Spotting-Verfahren durch den Anwender durchgeführt wird.

Die Reinigung erfolgt vorzugsweise auf nasschemischem Wege. Hierbei bietet sich die Anwendung einer Piranha-Lösung an. Diese besteht aus einer Mischung aus Wasserstoffperoxid und Schwefelsäure und stellt eine sehr wirkungsvolle Verbindung zur Reinigung der Oberfläche dar. Vorteilhaft ist die Monolage aus Fluorsilanverbindungen chemisch stabil genug, um diesen Reinigungsschritt zu überstehen.

Gemäß einer weiteren Ausgestaltung der Erfindung kann auch vorgesehen werden, dass nach erfolgter Reinigung die Funktionalisierung der Messbereiche mit einem Spotting-Verfahren sofort erfolgt. Der Anwender bekommt in diesem Fall die bereits funktionalisierten Chips zur Verfügung gestellt. Dies ist bei standardmäßig sehr oft angewendeten Analyse-Verfahren von Vorteil, da die Chips in großer Stückzahl sofort nach ihrer Herstellung funktionalisiert werden können. Auf diese Weise können Verunreinigung bei dem Verfahren gut ausgeschlossen werden.

Gemäß einem weiteren Aspekt der vorliegenden Erfindung wird ein Verfahren zur Herstellung eines Chips mit einer Vielzahl von elektrisch adressierbaren Messbereichen bzw. zum Erzeugen einer Vielzahl von Messbereichen auf einem Chip vorgeschlagen, wobei auf dem Chip in jedem der Messbereiche elektrisch kontaktierbare Elektrodenpaarungen strukturiert sind und wobei die Messbereiche durch Ausbilden einer die Messbereiche voneinander trennenden Compartment-Struktur ausgebildet werden.

Die Ausbildung der Compartment-Struktur umfasst dabei das Erzeugen von hydrophoben Benetzungseigenschaften auf der Chipoberfläche außerhalb der Messbereiche. Weiterhin kann die Ausbildung der Compartment-Struktur das Erzeugen von hydrophilen Eigenschaften in den Messbereichen umfassen.

Darüber hinaus kann es gemäß einem unabhängig realisierbaren Aspekt der vorliegenden Erfindung vorgesehen sein, dass die Messbereiche zumindest im Wesentlichen bis zum Einbau des Chips in ein elektrisches Bauteil mit einer Schutzschicht versehen sind. Unter der Bestimmung "bis zum Einbau" des Chips ist dabei jede Prozessstufe bei der Herstellung des Chips zu verstehen, bei welcher eine Entfernung der Schutzschicht sinnvoll ist. Dies kann unmittelbar vor dem Spotting-Verfahren sein, jedoch beispielsweise auch bereits unmittelbar nach dem Zerteilen des Wavers, aus dem der Chip gefertigt wird, oder nach dem elektrischen Kontaktieren (Bonden) des (vereinzelten) Chips.

Die Verwendung einer Schutzschicht, welche die Messbereiche zumindest im Wesentlichen bedeckt, ermöglicht eine vereinfachte Weiterverarbeitung des Chips. Dieser bzw. der Waver, aus dem der Chip hergestellt wird, kann beispielsweise zerteilt oder eklektisch angeschlossen oder außen mit einer Passivierung versehen oder eingegossen werden, ohne dass zu befürchten ist, dass die empfindlichen Messbereiche bzw. mit Metallen, wie Gold, bedampfte Flächen des Chips mechanischen, thermischen oder chemischen Belastungen ausgesetzt sind und beschädigt oder gar zerstört werden.

Im Rahmen der vorliegenden Erfindung werden dabei besonders gute Ergebnisse erhalten, wenn die Schutzschicht eine photostrukturierte Schicht bzw. ein Photolack ist. Photostrukturierte Schichten sind im Allgemeinen aus photostrukturierbaren Schichten erhältlich. Unter einer photostrukturierbaren Schicht ist im Rahmen der vorliegenden Erfindung insbesondere eine Schicht zu verstehen, deren Aggregatzustand und/oder chemische Beschaffenheit sich durch Einwirkung elektromagnetischer Strahlung, insbesondere durch UV-Strahlung, verändert, wodurch eine photostrukturierte Schicht entsteht. Insbesondere ist es in diesem Zusammenhang vorgesehen, dass allein die Bereiche der photostrukturierbaren Schicht einer Veränderung unterliegen, welche der elektromagnetischen Strahlung ausgesetzt sind. Die durch Einwirkung von elektromagnetischer Strahlung induzierte Veränderung der Schutzschicht kann insbesondere dergestalt sein, dass die Schicht fest wird oder sich verflüssigt, chemisch aushärtet, d. h. vernetzt, oder polymere Strukturen zerstört werden. Durch die Verwendung von Masken und beispielsweise und UV-Strahlern können somit Strukturen auf der Chipoberfläche erzeugt werden.

In diesem Zusammenhang kann es vorgesehen sein, dass die photostrukturierte Schicht einen Photolack enthält oder ein Photolack ist. Photolacke, welche üblicherweise unter Einwirkung von UV-Strahlung aushärten, sind dem Fachmann an sich bekannt und in großer Vielzahl kommerziell erhältlich.

Im Rahmen der vorliegenden Erfindung wird es bevorzugt, wenn sich bei der photostrukturierten Schicht um einen Photolack handelt, welcher auch im Rahmen der Hydrophobierung der Chipoberfläche eingesetzt wird. Auf diese Weise können im Rahmen der vorliegenden Erfindung Zeit, Material und apparativer Aufwand gespart werden, da die im Rahmen der Hydrophobierung aufgebrachte photostrukturierte Schicht, insbesondere der Photolack, zum Schutz der Messbereiche auch nach erfolgter Hydrophobierung auf den Messbereichen verbleibt und diese bis zum Einbau bzw. bis zur Beendigung der Prozessierung des Chips weiterhin schützt.

Wenn eine photostrukturierte Schicht als Schutzschicht für die im Rahmen der vorliegenden Erfindung eingesetzt wird, so ist es bevorzugt, wenn die photostrukturierte Schicht, insbesondere der Photolack, bei Temperaturen bis zu 150 °C, insbesondere 200 °C, vorzugsweise 250 °C, bevorzugt 300 °C, zumindest kurzzeitig chemisch und/oder physikalisch stabil ist. Bei der Verarbeitung des Chips, beispielsweise bei der Zerteilung oder des Einbaus in Devices, kann es immer wieder vorkommen, dass der Chip thermischen Spitzen, d. h. kurzzeitigen thermischen Belastungen, ausgesetzt ist. In diesem Fall darf sich die photostrukturierte Schicht bzw. der Photolack weder chemisch zersetzen noch darf sich die chemische bzw. physikalische Beschaffenheit derart verändern, dass die Messbereiche nicht mehr ausreichend geschützt sind oder die Schicht zu einem späteren Zeitpunkt nicht mehr zu entfernen ist.

Aus diesem Grund sollte die Schutzschicht bzw. die aufgebrachte photostrukturierte Schicht thermisch ausreichend stabil sein, und zwar insbesondere bei den bei der Chipverarbeitung kurzfristig auftretenden Temperaturspitzen.

Derartige thermisch widerstandsfähige photostrukturierte Schichten bzw. Photolacke sind im Rahmen der vorliegenden Erfindung vorteilhafterweise auf Polyamidbasis ausgebildet. Polyamidbasierte Photolacke besitzen oftmals eine ausgesprochen hohe thermische Stabilität von bis zu 400 °C und können darüber hinaus hydrophob ausgebildet sein.

Im Allgemeinen erfolgt die Hydrophobierung im Rahmen der vorliegenden Erfindung durch Aufbringung einer hydrophoben Schicht auf den Chip. In diesem Zusammenhang kann es vorgesehen sein, dass die hydrophobe Schicht in Form einer Lackschicht oder einer Monolage auf den Chip aufgebracht wird. Falls die hydrophobe Schicht als Lackschicht aufgebracht wird, so kann es sich hierbei insbesondere um photostrukturierte Schichten, insbesondere Photolacke, handeln, welche durch elektromagnetische Strahlung, insbesondere UV-Strahlung, aushärten oder depolymerisieren bzw. zerstört werden. Wenn im Rahmen der vorliegenden Erfindung die hydrophobe Schicht durch ein Photolack gebildet wird, insbesondere der Photolack durch eines der zuvor beschriebenen Verfahren auf den Chip aufgebracht wird, so erübrigt sich üblicherweise eine weitere Hydrophobierung der Chipoberfläche. In diesem Fall verbleibt der hydrophobe Photolack außerhalb der Messbereiche auf dem Chip und wird nicht wieder entfernt. Wird hingegen die hydrophobe Schicht durch eine Monolage gebildet, so hat es ich im Rahmen der vorliegenden Erfindung bewährt, wenn die Aufbringung der Monolage als selbstorganisierte Monolage erfolgt. Durch Monolagen lassen sich besonders scharf begrenzte hydrophobe Bereiche auf dem Chip erstellen.

Gleichfalls kann es im Rahmen der vorliegenden Erfindung auch vorgesehen sein, dass die Hydrophobierung durch Umsetzung mit reaktiven chemischen Verbindungen erfolgt. Vorzugsweise handelt es sich bei dem im Rahmen der vorliegenden Erfindung eingesetzten reaktiven chemischen Verbindungen um Silane, insbesondere Alkylsilane und /oder Fluorsilane. Wenn im Rahmen der vorliegenden Erfindung Alkylsilane verwendet werden, so hat es sich bewährt, wenn als Alkylsilane Trialkylsilane bzw. Silazane eingesetzt werden, vorzugsweise Trimethylchlorsilan und/oder Hexamethyldisilazan. Werden hingegen im Rahmen der vorliegenden Erfindung Fluorsilane eingesetzt, so hat es sich bewährt, wenn teil- oder perfluorierte Silane, besonders bevorzugt Tridecafluor-1,1,2,2-tetrahydrooctyl-trichlorsilan, verwendet werden bzw. wird.

Die Verwendung von Fluorsilanen ist dabei besonders bevorzugt, da diese sowohl über hervorragende hydrophobe Eigenschaften als auch exzellente chemische Beständigkeiten verfügen.

Für weitergehende Einzelheiten zu dem erfindungsgemäßen Verfahren kann auf die vorigen Ausführungen zu den übrigen Erfindungsaspekten verwiesen werden, welche in Bezug auf das erfindungsgemäße Verfahren entsprechend gelten.

In Bezug auf weitere Einzelheiten im Hinblick auf das erfindungsgemäße Verfahrens kann auf die Ausführungen zu den übrigen Erfindungsaspekten verwiesen werden, welche in Bezug auf das erfindungsgemäße Verfahren entsprechend gelten.

Schließlich ist wiederum weiterer Gegenstand der vorliegenden Erfindung - gemäß einem vierten Aspekt der vorliegenden Erfindung - ein Chip mit einer Vielzahl von Messbereichen, welcher nach den zuvor beschriebenen Verfahren erhältlich ist.

Für weitergehende Einzelheiten zu dem erfindungsgemäßen Chip kann auf die vorherigen Ausführungen zu den übrigen Erfindungsaspekten verwiesen werden, welche in Bezug auf den erfindungsgemäßen Chip entsprechend gelten.

Weitere Einzelheiten der Erfindung werden nachfolgend anhand der Zeichnung beschrieben. Gleiche oder sich entsprechende Zeichnungselemente sind in den Figuren jeweils mit den gleichen Bezugszeichen versehen und werden nur insoweit mehrfach erläutert, wie sich Unterschiede zwischen den einzelnen Figuren ergeben. Es zeigen:
- Fig. 1 bis 4: ausgewählte Verfahrensschritte eines ersten Ausführungsbeispiels des erfindungsgemäßen Verfahrens,
- Fig. 5 bis 7: ausgewählte Fertigungsschritte eines anderen Ausführungsbeispiels des erfindungsgemäßen Verfahrens,
- Fig. 8: einen Ausschnitt aus der Chipoberfläche eines Ausführungsbeispiels des erfindungsgemäßen Chips als dreidimensionale Ansicht, und
- Fig. 9: eine schematische Darstellung des Chips im angeschlossenen und eingebauten Zustand.

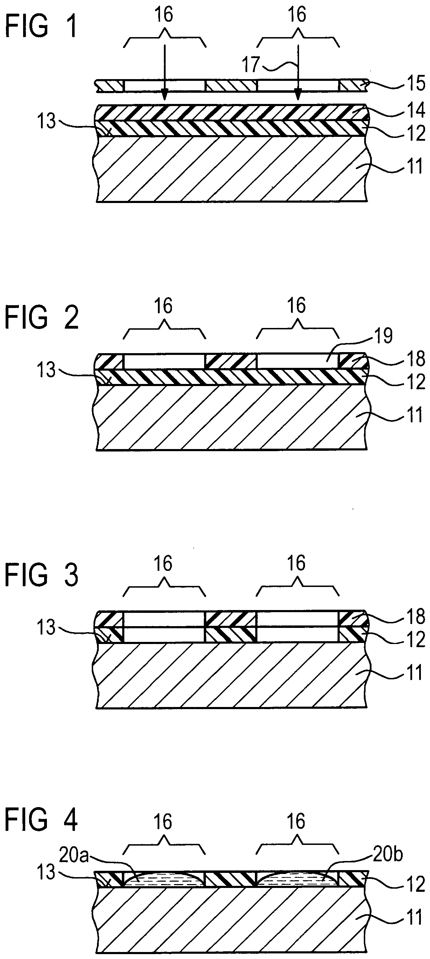

In Fig. 1 ist der Ausschnitt eines Chips 11 aus Silizium zu erkennen. Jedoch kann der Chip 11 auch aus einem anderen Material bestehen.

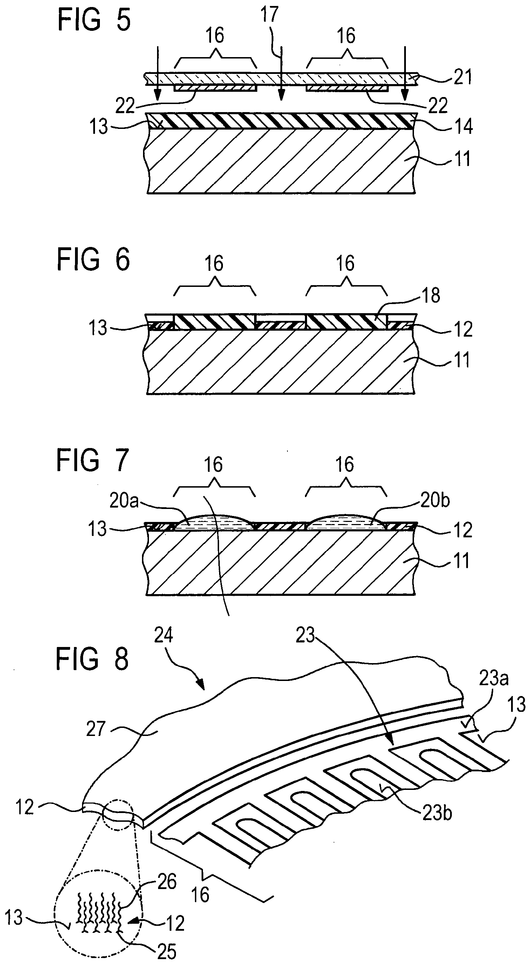

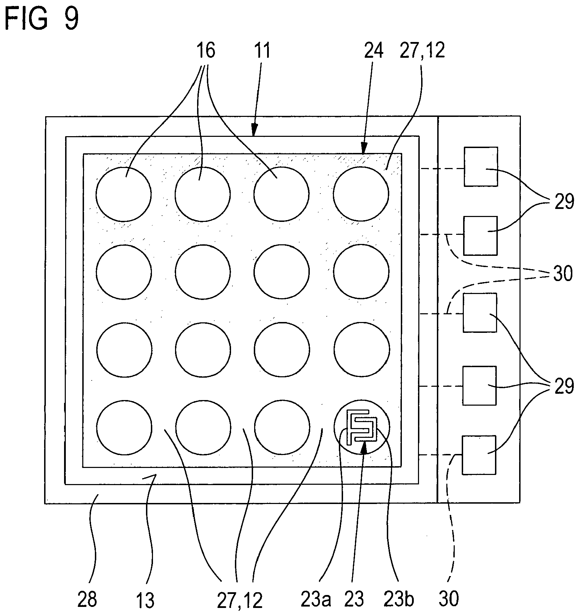

Besonders bevorzugt weist auf oder beinhaltet der Chip 11 elektronische Schaltungen und/oder in Fig. 1 nicht dargestellte Elektrodenanordnungen 23 (vergl. Fig. 8 und 9).

Der Chip 1 weist vorzugsweise eine hydrophobe Schicht 12, die als Monolayer bzw. Monolage ausgebildet sein kann und/oder bevorzugt eine Fluorsilanverbindung enthalten oder daraus gebildet sein kann.

Vorzugsweise ist auf dem Chip 11 zunächst eine Fluorsilanverbindung, insbesondere wie bereits oben beschrieben, in einem Exsikkator aufgedampft worden, wobei die Fluorsilanverbindung einen selbst organisierten Monolayer 12 auf der Chipoberfläche 13 ausgebildet hat. Nachfolgend ist eine photostrukturierbare Schicht 14 auf dem Monolayer 12 aufgebracht worden. Mittels einer Lochmaske 15 werden die Bereiche, die die späteren Messbereiche 16 ausbilden sollen (vgl. auch Fig. 4), mit Licht 17 belichtet.

Fig. 2 zeigt die photostrukturierte Schicht 18, nachdem die photostrukturierbare Schicht 14 entwickelt wurde. Hierdurch werden die hydrophilen Bereiche definiert, die die späteren Messbereiche 16 ergeben. Diese erscheinen als Fenster 19 in der photostrukturierten Schicht 18.

Der Fig. 3 lässt sich entnehmen, wie die hydrophilen Bereiche im Sauerstoffplasma hergestellt wurden. Die Monolage 12 ist im Bereich der Fenster 19 bis auf die Chipoberfläche 13 abgetragen worden. So entstehen die hydrophilen Messbereiche 16. Nachfolgend muss die photostrukturierte Schicht 18 noch von der Monolage 12 entfernt werden. Dies lässt sich Fig. 4 entnehmen. Fig. 4 zeigt auch, wie verschiedene Flüssigkeiten 20a, 20b auf die Messbereiche 16 aufgebracht werden, um diese Messbereiche zu funktionalisieren (Spotting-Verfahren). Auf diese Weise entsteht der fertig funktionalisierte Chip 11.

Das Verfahren gemäß den Fig. 5 bis 7 arbeitet ebenfalls mit einer photostrukturierbaren Schicht 14 und einer hydrophoben Schicht bzw. einer Monolage 12 (vgl. Fig. 6). Allerdings ist die Reihenfolge der Aufbringung dieser beiden Schichten im Vergleich zu dem gemäß Fig. 1 bis 4 beschriebenen Verfahren genau umgekehrt. Gemäß Fig. 5 wurde zunächst die photostrukturierbare Schicht 14 auf die Oberfläche 13 des Chips 11 aufgebracht.

Zur Strukturierung der photostrukturierbaren Schicht 14 wird vorzugsweise eine Belichtungsmaske 21 verwendet, die aus einer transparenten Scheibe besteht und im Bereich der späteren Messbereiche 16 eine lichtdichte Beschichtung 22 aufweist. Mit dem Licht 17 wird die photostrukturierbare Schicht 14 strukturiert.

Wie Fig. 6 zu entnehmen ist, verbleibt in den Messbereichen 16 die photostrukturierte Schicht 18, während die darum liegenden Bereiche bis auf die Chipoberfläche 13 freigelegt wurden. Diese Bereiche werden nun mit der hydrophoben Schicht bzw. selbst organisierten Monolage 12 insbesondere aus Fluorsilanen beschichtet.

Wie Fig. 7 zu entnehmen ist, wird die photostrukturierte Schicht 18 anschließend abgetragen, wobei die Messbereiche 16 freigelegt werden. Diese liegen direkt auf der Chipoberfläche 13. Die Funktionalisierung der Messbereiche 16 erfolgt, wie bereits beschrieben, durch ein Spotting-Verfahren, bei dem die Flüssigkeiten 20a, 20b aufgebracht werden.

Alternativ können die Messbereiche 16 auch erst später freigelegt werden. Die Messbereiche 16 werden dann durch die photostrukturierbare Schicht 14 bzw. photostrukturierte Schicht 18, also durch eine Schutzschicht, bzw. durch einen diesen bildenden Photolack o. dgl., geschützt, beispielsweise bis der Chip 11 von anderen (nicht dargestellten) Chips eines Wavers o. dgl. getrennt wurde und/oder bis der Chip 11 elektrisch angeschlossen (gebondet) und/oder außen mit einer Passivierungsschicht versehen und/oder eingegossen bzw. in ein Gehäuse eingebaut wurde.

Zur Bildung der photostruktierbaren Schicht 14 wird besonders bevorzugt ein Photolack eingesetzt. Besonders bevorzugt wird ein polyamidbasierter Photolack, insbesondere aufgrund seiner thermischen Stabilität, eingesetzt.

Gemäß einer weiteren Alternative wird die strukturierbare bzw. strukturierte Schicht 14, 18 bzw. der Photolack vorzugsweise anstelle der Monolage 12 bzw. Fluorsilanverbindung zur Bildung der hydrophoben Schicht 12 bzw. Compartment-Struktur 24 eingesetzt. Die photostrukturierbare Schicht 14, wie in Fig. 5 angedeutet, bildet dann in den gewünschten Bereichen die hydrophobe Schicht bzw. Beschichtung und damit die Compartment-Struktur 24 bzw. Zwischenbereiche 27. Das Verfahren wird dann insoweit vereinfacht, da vorzugsweise nur noch die Schicht 14 bzw. der Photolack zur Bildung der Messbereiche 16 entfernt werden muss, das Aufbringen einer zweiten Schicht also entfällt. In diesem Fall ist der Photolack dann vorzugsweise entsprechend hydrophob ausgebildet oder gemäß einer weiteren Alternative hydro-phobierbar.

In Fig. 8 ist der Rand eines Messbereichs 16 auf der Chipoberfläche 13 ausschnittweise zu erkennen. Der Messbereich 16 weist eine Elektrodenpaarung bzw. -anordnung 23 auf, die vorzugsweise aus einer ersten Elektrode 23a und einer zweiten Elektrode 23b besteht. Diese Elektroden weisen vorzugsweise Finger auf, die insbesondere ineinander verzahnt sind. Diese Elektrodenanordnung 23 reagiert sehr empfindlich darauf, dass nicht näher dargestellte funktionelle Moleküle, die in dem Messbereich 16 immobilisiert sind, mit nachzuweisenden Molekülen reagieren.

Der Messbereich 16 ist außerdem mit einer Compartment-Struktur 24 umgeben, die nur ausschnittsweise dargestellt ist. Ein Teil dieses Ausschnitts ist vergrößert dargestellt, wobei zu erkennen ist, dass die Compartment-Struktur 24 vorzugsweise aus der Schicht- bzw. Monolage 12 gebildet ist. Diese besteht insbesondere aus Molekülen der Fluorsilanverbindung, wobei diese Moleküle mit ihrer funktionellen Gruppe 25 auf der Oberfläche 13 des Chips 11 angedockt sind, während der Molekülrest 26, der die stark hydrophoben Eigenschaften der Monolage 12 erzeugt, nach oben bzw. davon absteht.

Vorzugsweise bildet die Compartment-Struktur 24 bzw. die hydrophobe Schicht 12 - insbesondere auf ihrer freien Oberfläche - einen hydrophoben Zwischenbereich 27 zwischen den (benachbarten) Messbereichen 16, so dass in Fig. 8 nicht dargestellte Flüssigkeiten 20a, 20b beim Spotten - also Aufbringen von Flüssigkeitstropfen auf die Messbereiche 16, insbesondere zum Immobilisieren von nicht gezeigten Fängermolekülen o. dgl. - nicht in benachbarte Messbereiche 16 strömen bzw. sich nicht mit benachbarten Flüssigkeiten mischen oder fluidisch verbinden.

Die Compartment-Struktur 24 bzw. hydrophobe Schicht 12 bzw. der jeweilige Zwischenbereich 27 ist daher vorzugsweise hydrophob, insbesondere stark hydrophob, ausgebildet.

Besonders bevorzugt beträgt der Kontaktwinkel der Compartment-Struktur 24 bzw. der hydrophoben Schicht 12 bzw. der Zwischenbereiche 27 zu Wasser zumindest im Wesentlichen 90°, vorzugsweise mehr als 120°, ganz besonders bevorzugt mehr als 150°, jeweils gemessen bei Normalbedingungen mit destilliertem Wasser.

Fig. 9 zeigt in einer sehr schematischen Draufsicht den vorschlagsgemäßen Chip 11 im angeschlossenen und eingebauten Zustand bzw. den Chip 11 mit oder in einem Gehäuse 28.

Vorzugsweise wird der Chip 11 zusammen mit anderen Chips 11 in einem üblichen Verfahren, beispielsweise in CMOS-Technik, auf einem gemeinsamen Träger oder Substrat, insbesondere einem sogenannten Waver, hergestellt. Anschließend werden die Chips 11 voneinander getrennt, elektrisch angeschlossen und vorzugsweise eingebaut, insbesondere in ein zugeordnetes Gehäuse 28 o. dgl.

Beim Darstellungsbeispiel ist der Chip 11 vorzugsweise an Kontaktflächen bzw. Anschlüsse 29 elektrisch angeschlossen, insbesondere über gestrichelt angedeutete elektrische Verbindungen 30. Dies ist hier nur schematisch dargestellt. Das elektrische Anschließen des Chips 11 wird üblicherweise als Bonden bezeichnet.

Im eingebauten Zustand sind zumindest die Messbereiche 16 zur Aufnahme von zu messenden Proben (nicht dargestellt) zugänglich.

In Fig. 9 ist die Compartment-Struktur 24 ersichtlich, die mit ihren Zwischenbereichen 27 bzw. hydrophoben Schichten 12 die Messbereiche 16 (vollständig) umgibt und/oder voneinander trennt. Insbesondere wird eine gitterartige oder wabenartige Struktur gebildet, wobei jeder Messbereich 16 vorzugsweise ringförmig umgeben ist.

Wie bereits erwähnt können die Messbereiche 16 durch eine Schutzschicht, insbesondere eine Schicht 14, besonders bevorzugt aus Photolack, überdeckt bzw. geschützt sein. Diese Schutzschicht wird dann vorzugsweise erst nach dem Zerteilen bzw. Vereinzeln der 11 und/oder nach dem elektrischen Anschließen und/oder Einbau des jeweiligen Chips 11 entfernt. Jedoch ist auch eine frühere Freilegung der Messbereiche 16 möglich.

Wenn das Entfernen der Schutzschicht erst nach dem Einbau erfolgt, ist die Schutzschicht besonders bevorzugt ausreichend thermisch stabil ausgebildet. Beim Einbau wird der Chip 11 nämlich insbesondere eingegossen. Aufgrund der hierbei auftretenden Temperaturen kann ein üblicher Photolack verhärten. Dies würde das anschließende Entfernen in den Messbereichen 16 zumindest erschweren oder gar unmöglich machen. Dementsprechend wird vorzugsweise ein Photolack eingesetzt, der ausreichend thermisch stabil ist, ohne das er verhärtet. Hierzu eignet sich insbesondere ein polyamidbasierter Photolack.

In Fig. 9 ist schematisch nur in einem Messbereich 16, nämlich in dem rechten unteren Messbereich 16, eine Elektrodenanordnung 23 angedeutet. Insbesondere sind derartige, vorzugsweise identische oder ähnliche Elektrodenanordnungen 23, in allen Messbereichen 16 gebildet bzw. angeordnet.

Die Bildung der Elektrodenanordnungen 23 erfolgt vorzugsweise vor dem Erzeugen oder Aufbringen der Compartment-Struktur 24.

Die Elektrodenanordnungen 23 liegen vorzugsweise zumindest im Wesentlichen in der Chipoberfläche 13, auf der die Messbereiche 16 gebildet werden und die Compartment-Struktur 24 aufgebaut wird.

Die Chipoberfläche 13 ist vorzugsweise zumindest im Wesentlichen eben ausgebildet und/oder stellt vorzugsweise eine Flachseite des Chips 11 dar.

Beim Darstellungsbeispiel hängen die hydrophoben Schichten 12 bzw. Zwischenbereiche 27 vorzugsweise aneinander und/oder bilden ein zusammenhängendes Gitter. Jedoch können diese auch separate Bereiche oder Abschnitte auf der Chipoberfläche 13 bilden, die jeweils einen oder mehrere Messbereiche 16 umgeben bzw. umschließen.

Vorzugsweise können in den Messbereichen 16 unterschiedliche zu detektierende Moleküle mittels der Elektrodenanordnungen 23 detektiert werden. Entsprechende Detektionssignale werden insbesondere elektrisch von dem Chip 11 ausgegeben bzw. sind vorzugsweise elektrisch abfragbar.

Vorzugsweise ist die Compartment-Struktur 24 gegenüber der zumindest im Wesentlichen ebenen Chipoberfläche 13 erhaben.

Vorzugsweise umgibt die Compartment-Struktur 24 jeden Messbereich 16 vollständig bzw. ringartig mit der hydrophoben Schicht 12 bzw. dem hydrophoben Zwischenbereich 27.

Insbesondere ist die Compartment-Struktur 24 bzw. hydrophobe Schicht 12 oder Monolage bzw. der Zwischenbereich 27 gitterartig und/oder wabenartig ausgebildet.

Die Compartment-Struktur 24 bzw. hydrophobe Schicht 12 bzw. Zwischenbereiche 27 ist bzw. sind vorzugsweise als flächige und/oder ebene Beschichtung ausgebildet.

Vorzugsweise weist die Compartment-Struktur 24 bzw. hydrophobe Schicht 12 bzw. der Zwischenbereich 27 eine geringere Höhe als Breite auf. Besonders bevorzugt ist die Breite zwischen zwei benachbarten Messbereichen 16 mindestens um den Faktor 5, vorzugsweise mindestens um den Faktor 10, größer als die Höhe gegenüber der die Messbereiche 16 tragenden Chipoberfläche 13.

Besonders bevorzugt beträgt die Höhe der Compartment-Struktur 24 bzw. hydrophoben Schicht 12 bzw. des hydrophoben Zwischenbereichs 27 weniger als 2 µm, insbesondere weniger als 1 µm, und/oder mehr als 10 nm, insbesondere mehr als 100 nm.

Besonders bevorzugt weisen die Zwischenbereiche 27 eine Breite zwischen den Messbereichen 16 von mehr als 10%, insbesondere mehr als 20%, besonders bevorzugt etwa 50% oder mehr, eines Messbereichs 16 auf.

Besonders bevorzugt weisen die Zwischenbereiche 27 eine Breite zwischen den Messbereichen 16 von mehr als 5 µm, insbesondere mehr als 10 µm oder 20 µm, besonders bevorzugt mehr als 50 µm, auf.

Die Messbereiche 16 weisen vorzugsweise eine Breite bzw. einen mittleren Durchmesser von mehr als 50 µm, insbesondere mehr als 100 µm, und/oder von weniger als 500 µm, vorzugsweise weniger als 300 µm, insbesondere weniger als 200 µm, ganz besonders bevorzugt etwa von 120 bis 180 µm, auf.

Vorzugsweise werden bei dem sogenannten Spotten Flüssigkeitstropfen 20a, 20b auf die einzelnen Messbereiche 16, insbesondere jeweils mit einem Volumen von 1.000 bis 2.000 pl, aufgegeben, wobei die hydrophoben Schichten 12 bzw. Zwischenbereiche 27 dafür sorgen, dass die Flüssigkeitstropfen 20a, 20b auf dem jeweiligen Messbereich 16 lokalisiert bleiben bzw. sich nicht mit benachbarten Flüssigkeitstropfen 20a, 20b vermischen und/oder nicht in einen benachbarten Messbereich 16 fließen.

Das genannte Spotten kann grundsätzlich wahlweise vor oder nach dem Vereinzeln der Chips 11 und/oder dem elektrischen Anschließen und Einbau des jeweiligen Chips 11 erfolgen. Vorzugsweise erfolgt das Spotten nach dem Anschließen und Einbau des Chips 11.

Das Spotten bzw. Aufbringen von Flüssigkeitstropfen 20a, 20b dient insbesondere nur der Funktionalisierung der einzelnen Messbereiche 16, also insbesondere dem Abscheiden bzw. Binden von speziellen Molekülen zum Fangen oder Reagieren mit in einer Probe nachzuweisenden Molekülen. Die Flüssigkeitstropfen werden insbesondere nach einem gewünschten Immobilisieren oder Binden der speziellen Moleküle wieder entfernt. Das Spotten dient also insbesondere der Vorbereitung des Chips 11 bzw. der Messbereiche 16.

Die eigentliche Probenflüssigkeit mit nachzuweisenden bzw. zu detektierenden Molekülen wird später auf den Chip 11 bzw. die Messbereiche 16 - beispielsweise ganzflächig und/oder unter Einsatz von einer die Messbereiche 16 mit der darauf befindlichen Probenflüssigkeit möglichst flach abdeckenden Membran - aufgegeben, wenn der Chip 11 bestimmungsgemäß verwendet bzw. eingesetzt wird. Die Membran kann hierbei mit der Compartment-Struktur 24 interagieren, insbesondere auf dieser Aufliegen, um die Probenflüssigkeit auf die Messbereiche 16 aufzuteilen und/oder eine fluidische Trennung der Probenflüssigkeit in den verschiedenen Messbereichen 16 voneinander zu erreichen.

Alternativ ist es jedoch auch möglich, eine oder mehrere zu messende Proben durch Spotten auf die bereits funktionalisierten Messbereiche 16 aufzubringen.

Einzelne Aspekte und Merkmale der verschiedenen Ausführungsformen, Varianten und Alternativen können auch unabhängig voneinander, aber auch in beliebiger Kombination realisiert werden.

### Bezugszeichenliste:

- 11: Chip
- 12: Monolayer
- 13: Chipoberfläche
- 14: photostrukturierbare Schicht
- 15: Lochmaske
- 16: Messbereich
- 17: Licht
- 18: photostrukturierte Schicht
- 19: Fenster
- 20a, b: Flüssigkeit
- 21: Belichtungsmaske
- 22: lichtdichte Beschichtung
- 23: Elektrodenanordnung
- 23a, b: Elektrode
- 24: Compartment-Struktur
- 25: funktionelle Gruppe
- 26: Molekülrest
- 27: Zwischenbereich
- 28: Gehäuse
- 29: Anschluss
- 30: elektrische Verbindung

## Patentansprüche

1. Verfahren zur Herstellung eines Chips (11) mit einer Vielzahl von elektrisch adressierbaren Messbereichen (16) bzw. zum Erzeugen einer Vielzahl von Messbereichen (16) auf einem Chip (11), wobei auf dem Chip (11) in jedem der Messbereiche (16) elektrisch kontaktierbare Elektrodenpaarungen (23a, 23b) strukturiert sind und wobei die Messbereiche (16) durch Ausbilden einer die Messbereiche (16) voneinander trennenden Compartment-Struktur (24) ausgebildet werden, wobei die Ausbildung der Compartment-Struktur (24) folgende Verfahrensschritte umfasst:
- Erzeugen von hydrophoben Benetzungseigenschaften auf der Chipoberfläche (13) außerhalb der Messbereiche (16) durch Aufbringung einer hydrophoben Schicht (12) auf die Chipoberfläche (13), wobei die hydrophobe Schicht (12) in Form einer Schicht eines hydrophoben Photolacks auf die Chipoberfläche (13) aufgebracht wird, wobei der Photolack ein polyamidbasierter Photolack ist, und
- Erzeugen von hydrophilen Eigenschaften in den Messbereichen (16), wobei das Erzeugen der hydrophilen Eigenschaften in einem Sauerstoffplasma oder durch Trockenätzen vorgenommen wird.

2. Verfahren nach Anspruch 1, **dadurch gekennzeichnet, dass** die Messbereiche (16) zumindest im Wesentlichen bis zum Vereinzeln oder Einbau des Chips (11) mit einer Schutzschicht versehen oder abgedeckt sind bzw. werden.

3. Verfahren nach Anspruch 1 oder 2, **dadurch gekennzeichnet, dass** nach Abschluss der Verfahrensschritte gemäß einem der voranstehenden Ansprüche, eine Reinigung der prozessierten Chipoberfläche (13) bzw. Messbereiche (16) erfolgt.

4. Verfahren nach Anspruch 3, **dadurch gekennzeichnet, dass** die Reinigung auf nasschemischen Wege, insbesondere unter Anwendung eine Piranha-Lösung erfolgt.

5. Verfahren nach Anspruch 3 oder 4, **dadurch gekennzeichnet, dass** nach erfolgter Reinigung die Funktionalisierung der Messbereiche (16) mit einem Spotting-Verfahren erfolgt.

6. Verfahren nach einem der voranstehenden Ansprüche, **dadurch gekennzeichnet, dass** die hydrophoben Zwischenbereiche (27) eine Breite zwischen den Messbereichen (16) von mehr als 10 %, insbesondere mehr als 20 %, eines Messbereichs (16) aufweisen.

## Claims

1. Method for producing a chip (11) having a plurality of electrically addressable measurement regions (16) or for producing a plurality of measurement regions (16) on a chip (11), wherein on the chip (11) in each of the measurement regions (16) electrically contactable electrode pairings (23a, 23b) are structured and wherein the measurement regions (16) are formed by forming a compartmental structure (24) which separates the measurement regions (16) from one another, wherein the formation of the compartmental structure (24) comprises the following process steps:
- producing hydrophobic wetting properties on the chip surface (13) outside the measurement regions (16) by applying a hydrophobic layer (12) onto the chip surface (13), wherein the hydrophobic layer (12) is applied onto the chip surface (13) in form of a layer of a hydrophobic photoresist, wherein the photoresist is a polyamide-based photoresist, and
- producing hydrophilic properties in the measurement regions (16), wherein the production of the hydrophilic properties is carried out in an oxygen plasma or by dry etching.

2. Method according to claim 1, **characterised in that** the measurement regions (16) are at least substantially provided with a protective layer or covered until the chips (11) are divided or installed.

3. Method according to claim 1 or 2, **characterised in that** after the completion of the process steps according to one of the preceding claims, a cleaning of the processed chip surface (13) and/or measurement regions (16) is carried out.

4. Method according to claim 3, **characterised in that** the cleaning is carried out by a wet-chemical method, particularly using a piranha solution.

5. Method according to claim 3 or 4, **characterised in that** after the cleaning has been completed the functionalization of the measurement regions (16) is carried out with a spotting process.

6. Method according to one of the preceding claims, **characterised in that** the hydrophobic intermediate regions (27) have a width between the measurement regions (16) of more than 10 %, particularly more than 20 %, of a measurement region (16).

## Revendications

1. Procédé pour fabriquer une puce (11) avec une pluralité de zones de mesure (16) adressables électriquement ou pour produire une pluralité de zones de mesure (16) sur une puce (11), dans lequel sur la puce (11) des appariements d'électrode (23a, 23b) pouvant être en contact électriquement dans chacune des zones de mesure (16) sont structurés et dans lequel les zones de mesure (16) sont réalisées par réalisation d'une structure de compartiment (24) séparant les zones de mesure (16) les unes des autres, dans lequel la réalisation de la structure de compartiment (24) comprend les étapes de procédé suivantes :
- génération de propriétés d'humidification hydrophobes sur la surface de puce (13) en dehors des zones de mesure (16) par application d'une couche hydrophobe (12) sur la surface de puce (13), où la couche hydrophobe (12) est appliquée sous la forme d'une couche d'une résine photosensible hydrophobe sur la surface de puce (13), où la résine photosensible est une résine photosensible à base de polyamide, et
- génération de propriétés hydrophiles dans les zones de mesure (16), dans lequel la génération des propriétés hydrophiles est entreprise dans un plasma d'oxygène ou par gravure sèche.

2. Procédé selon la revendication 1, **caractérisé en ce que** les zones de mesure (16) sont ou seront pourvues ou recouvertes d'une couche de protection au moins sensiblement jusqu'à séparation ou intégration de la puce (11).

3. Procédé selon la revendication 1 ou 2, **caractérisé en ce qu'**à la fin des étapes de procédé selon l'une quelconque des revendications précédentes, un nettoyage de la surface de puce traitée (13) et/ou des zones de mesure (16) est effectué.

4. Procédé selon la revendication 3, **caractérisé en ce que** le nettoyage est effectué par voie chimique humide, en particulier en appliquant une solution Piranha.

5. Procédé selon la revendication 3 ou 4, **caractérisé en ce qu'**après la réalisation du nettoyage la fonctionnalisation des zones de mesure (16) est effectuée avec un procédé de spotting.

6. Procédé selon l'une quelconque des revendications précédentes, **caractérisé en ce que** les zones intermédiaires hydrophobes (27) présentent une largeur entre les zones de mesure (16) de plus de 10 %, en particulier plus de 20 % d'une zone de mesure (16).
